# EUROPÄISCHE PATENTANMELDUNG

(11) **EP 4 438 767 A1**
(43) Veröffentlichungstag der Anmeldung: **02.10.2024**
(21) Anmeldenummer: 24162225.7
(22) Anmeldetag: 08.03.2024
(51) Int. Cl.: C23C 16/04, B65G 29/00, B65G 47/84, C23C 16/50, C23C 16/54

(54) **BESCHICHTUNGSANLAGE SOWIE VERFAHREN ZUM BETREIBEN**

(30) Priorität: 31.03.2023 DE 102023108306
(71) Anmelder: KHS GmbH, 44143 Dortmund (DE)
(72) Erfinder: Schetle, Andreas, 21031 Hamburg (DE); Demirel, Ali Orhan, 22547 Hamburg (DE)
(74) Vertreter: Andrejewski - Honke Patent- und Rechtsanwälte Partnerschaft mbB

(57) **Zusammenfassung**

Die Erfindung betrifft eine Beschichtungsanlage, insbesondere Behälterbeschichtungsanlage, mit einer Einlauf- und einen Auslaufsternanordnung (1, 2) und einem dazwischen angeordneten und rotierbar antreibbaren Beschichtungsrad (3), welches eine Vielzahl von in Umfangsrichtung angeordneten Behälteraufnahmen aufweist, denen jeweils eine Beschichtungseinheit (4) zugeordnet ist, wobei die Beschichtungseinheit (4) dazu eingerichtet ist, in einem ersten Betriebszustand die Behälter während der Übergabe von der Einlauf- in die Auslaufsternanordnung (1, 2) zu beschichten und wobei zumindest ein Bypassrad (6) dazu eingerichtet ist, in einem zweiten Betriebszustand die Behälter unmittelbar von der Einlauf- in die Auslaufsternanordnung (1, 2) zu übergeben. Erfindungsgemäß ist das Bypassrad (6) über eine Stellanordnung (10) zwischen einer ersten und zumindest einer zweiten Stellung überführbar ist.

## Beschreibung

Die Erfindung betrifft eine Beschichtungsanlage, insbesondere eine Behälterbeschichtungsanlage, mit einer Einlauf- und einer Auslaufsternanordnung und einem dazwischen angeordneten und rotierbar antreibbaren Beschichtungsrad, welches eine Vielzahl von der Umfangsrichtung angeordneten Behälteraufnahmen aufweist, den jeweils eine Beschichtungseinheit zugeordnet ist, wobei die Beschichtungseinheit dazu eingerichtet ist, in einem ersten Betriebszustand die Behälter während der Übergabe von der Einlauf- in die Auslaufsternanordnung zu beschichten und wobei zumindest ein Bypassrad dazu eingerichtet ist, in einem zweiten Betriebszustand die Behälter unmittelbar von der Einlauf- in die Auslaufsternanordnung zu übergeben.

Derartige Behälterbeschichtungsanlagen sind grundsätzlich aus dem Stand der Technik bekannt und dienen dazu, Behälter mit einer Innenbeschichtung zu versehen. Die Erfindung bezieht sich insbesondere auf Behälter aus dem Bereich der Lebensmitteltechnik, insbesondere der Getränketechnik. Entsprechend handelt es sich bei den Behältern um Getränkebehälter, beispielsweise um Getränkeflaschen. Die Getränkebehälter bestehen insbesondere aus Kunststoff z.B. aus Polyethylenterephthalat (PET) und werden vor der Beschichtung üblicherweise im Rahmen einer Blasumformung aus Vorformlingen ausgeformt.

Da insbesondere Polyethylenterephthalat nur geringe Barriereeigenschaften gegen das Eindringen von Sauerstoff und/oder das Austreten von Kohlendioxid oder anderen Gasen aufweist, kann mithilfe einer entsprechenden Beschichtungsanlage eine zusätzliche Barriereschicht innenliegend auf die Behälterwandungen aufgebracht werden.

Eine solche Beschichtung erfolgt üblicherweise mithilfe sogenannter Plasmabeschichtungsverfahren, wobei aus einem Plasma heraus die entsprechenden Schichten abgeschieden werden und sich auf den Wandungen des Getränkebehälters absetzen. In diesem Zusammenhang ist auch von sogenannten PICVD-Verfahren ("Plasma Impuls Chemical Vapor Deposition") die Rede, wobei insbesondere Schichten aus Siliziumoxid abgeschieden werden. Entsprechende Verfahren sind zum Beispiel aus der WO 03/100125 A1 und aus der WO 03/100121 A2 bekannt.

Die Beschichtung der Behälter erfolgt im Beschichtungsrad. Hierzu weist das Beschichtungsrad eine Vielzahl von Beschichtungseinheiten auf, welche üblicherweise gemeinsam mit der zugeordneten Behälterausformung ausgebildet sind. Während der Beschichtung werden die Behälter innerhalb der Behälteraufnahmen zunächst evakuiert und sodann durch Einbringen verschiedener Gase die entsprechende Barriereschicht aus dem Plasma abgeschieden.

In modernen Abfüllanlagen sind die Beschichtungsanlagen Teil einer sogenannten verblockten Anlage. Dies bedeutet, dass die einzelnen Behandlungsanlagen unmittelbar über sogenannte Transfersterne miteinander in Verbindung stehen, sodass entsprechend die Behälter unmittelbar von einer Anlagenkomponente an eine weitere Anlagenkomponente übergeben werden. Dies setzt voraus, dass die entsprechenden Abfüllanlagen auch in der Lage dazu sind, verschiedene Arten von Behältern zu behandeln, um einen möglichst flexiblen Einsatz zu ermöglichen. Hierbei können sich die Behälter insbesondere in ihrer Größe voneinander unterscheiden.

In diesem Zusammenhang ist es wesentlich, dass eine Beschichtung üblicherweise bei vergleichsweise kleinen Behältern, insbesondere kleinen Getränkeflaschen, erfolgt, während bei größeren Behältern eine Beschichtung nicht zwingendermaßen notwendig ist. Dies ergibt sich allein aus dem Umstand, dass größere Flaschen ein kleineres Verhältnis aus Oberfläche zu Volumen aufweisen als kleinere Flaschen, sodass der Gaseintritt bzw. der Gasaustritt in vergleichsweise gering ist.

Aufgrund der verblockten Bauweise der Abfüllanlagen müssen allerdings auch Behälter, welche nicht einer Beschichtung unterzogen werden sollen, durch das Beschichtungsrad geführt werden, wobei das Beschichtungsrad hinsichtlich der Ausgestaltung der Behälteraufnahmen gewissen Grenzen hinsichtlich der maximalen Behältergröße bestehen. Vor diesem Hintergrund ist es aus dem Stand der Technik bekannt, zwischen der Einlauf- und der Auslaufsternanordnung ein Bypassrad anzuordnen, welches unter Umgehung des Beschichtungsrades unmittelbar die Behälter von der Einlauf- in die Auslaufsternanordnung übergibt.

Eine entsprechende Ausgestaltung ist beispielsweise aus der EP 3 281 768 B1 bekannt. Gemäß der dort gezeigten Ausgestaltung ist dem Einlauf- und dem Auslaufstern jeweils ein zusätzlicher Transportstern vor- bzw. nachgeschaltet, wobei das Bypassrad zwischen diesen Transportsternen angeordnet ist. Der Einlaufstern und der Auslaufstern verfügen darüber hinaus über sogenannte aktive Greifer, sodass die Behälter lediglich dann in den Einlaufstern übergeben werden, wenn die Greifer entsprechend geschaltet sind. Ist dies nicht der Fall erfolgt keine Übergabe zwischen dem Einlaufstern und dem zugeordneten Transportstern, sodass die Behälter in dem Transportstern weiter rotieren und an das Bypassrad übergeben werden.

Dieses Prinzip hat sich grundsätzlich bewährt. Allerdings wird durch das zusätzliche Bypassrad die Zugänglichkeit der Einlauf- und der Auslaufsternanordnung wesentlich verschlechtert. Entsprechend sind bei Wartungsarbeiten umfangreiche Umbaumaßnahmen erforderlich.

Der Erfindung liegt daher die Aufgabe zugrunde, eine Beschichtungsanlage anzugeben, welche sich durch eine wartungsfreundliche und zugleich möglichst störungsunanfällige Ausgestaltung auszeichnet.

Gegenstand und Lösung der Aufgabe ist eine Beschichtungsanlage gemäß Patentanspruch 1. Demnach ist das Bypassrad über eine Stellanordnung zwischen einer ersten und zumindest einer zweiten Stellung überführbar. Der Kerngedanke der Erfindung liegt also darin, dass das Bypassrad verstellbar zwischen einer ersten und zumindest einer zweiten Stellung ausgebildet ist, sodass das Bypassrad lediglich zwischen der Einlauf- und der Auslaufsternanordnung angeordnet wird, sofern eine Umgehung des Beschichtungsrades erforderlich ist. Entsprechend können über die Stellanordnung die Betriebszustände eingestellt werden.

Sofern im Gegensatz dazu eine Beschichtung der Behälter erfolgen soll, wird das Beschichtungsrad in eine erste Stellung überführt, in welcher dieses nicht mit der Einlauf -und Auslaufsternanordnung in Wirkverbindung steht. Entsprechend ist dieser Bereich frei und kann insbesondere für Wartungsarbeiten genutzt werden. Der erste Betriebszustand wird entsprechend über die erste Stellung und der zweite Betriebszustand über die zweite Stellung des Bypassrades bewirkt.

Besonders bevorzugt ist in diesem Zusammenhang eine Ausgestaltung, bei der die Einlaufsternanordnung einen Einlaufstern und die Auslaufsternanordnung einen Auslaufstern aufweisen, welche unmittelbar an das Beschichtungsrad und an das Bypassrad angrenzen. Im Gegensatz zu dem aus der Stand der Technik bekannten Lösungen erfolgt also die Anordnung des Bypassrades unmittelbar an dem Einlaufstern und den Auslaufstern, wobei über den Einlaufstern die Behälter in das Beschichtungsrad eingeführt und über den Auslaufstern wieder abgeführt werden. Es wird folglich eine besonders platzsparende Lösung vorgeschlagen, welche insbesondere dem Erfordernis Rechnung trägt, dass die Beschichtungsanlage einen möglichst geringen Bauraum erfordert.

Gemäß einer Weiterbildung der Erfindung weisen das Bypassrad und/oder die Transportsternanordnung passive Greifer auf. Insbesondere ist vorgesehen, dass ausschließlich passive Greifer verwendet werden. Das Bypassrad kann allerdings auch aktive Greifer aufweisen. Gemäß einer solchen Ausgestaltung ist es also nicht möglich, anhand der Steuerung der Einlauf- und Auslaufsterne das Einbringen in das Beschichtungsrad oder das Bypassrad zu steuern. Vielmehr erfolgt ausschließlich durch Stellung des Bypassrades die Einstellung des Betriebszustandes. Hierbei ist zu beachten, dass gemäß der üblichen Ausgestaltung und Anordnung der Einlauf- und Auslaufsternanordnung die Behälter zunächst an dem Bypassrad vorbeigeführt und erst dann in das Beschichtungsrad eingebracht werden. Sofern also das Bypassrad in der zweiten Stellung positioniert ist, erfolgt zwingendermaßen das Einbringen in das Bypassrad und somit das Vorbeiführen der Behälter an dem Beschichtungsrad. Erst durch Stellung des Bypassrades in die erste Stellung ist es möglich, die Wirkverbindung zwischen der Einlaufsternanordnung und dem Bypassrad zu lösen, sodass das Einbringen der Behälter in das Beschichtungsrad ermöglicht wird. Bei den passiven Greifern kann es sich insbesondere um Zangen handeln, in welche die Behälter beispielsweise durch entsprechend zugeordnete Stellelemente hineingedrückt oder aus diesen herausgedrückt werden.

Eine Weiterbildung der Erfindung sieht vor, dass die Stellanordnung eine Linearführung aufweist, über die das Bypassrad zwischen der ersten und der zweiten Stellung bewegbar ist. Entsprechend erfolgt also das Überführen des Bypassrades zwischen der ersten und der zweiten Stellung durch eine lineare Bewegung.

Insbesondere handelt es sich hierbei um eine Bewegung parallel zur Drehachse des Bypassrades, sodass entsprechend die Linearführung im Wesentlichen parallel zur Drehachse des Bypassrades angeordnet ist. In diesem Zusammenhang ist mit einer im Wesentlichen parallelen Anordnung gemeint, dass eine Abweichung von +/- 5° möglich ist. Diese Abweichung trägt dem Umstand Rechnung, dass das Bypassrad möglichst spielfrei zwischen dem Einlaufstern und dem Auslaufstern angeordnet werden muss, um eine klemmfreie Übergabe der Behälter zu ermöglichen. Zugleich sind das Einlaufrad und das Auslaufrad bezüglich des Beschichtungsrades festgelegt, wobei gemäß einer üblichen Ausgestaltung zumindest der Einlauf- und der Auslaufstern über eine Getriebeanordnung, insbesondere über Zahnräder, fest mit dem Beschichtungsrad gekoppelt sind. Folglich führt die Anordnung des Bypassrades dazu, dass die gesamte Anordnung überbestimmt und eine möglichst fein justierte Einstellung des Bypassrades für eine klemmfreie erforderlich ist. In diesem Fall kann es erforderlich sein, geringe Toleranzen bezüglich der Lage der Linearführung in Kauf zu nehmen.

Gemäß einer solchen Ausgestaltung ist die Position der Drehachse des Bypassrades in der zweiten Stellung zwischen 70 mm und 1700 mm, insbesondere zwischen 100 und 1400 mm, von der Position in der ersten Stellungbeabstandet. Hierbei ist es grundsätzlich ausreichend, wenn nur eine geringe Beabstandung erfolgt, welche sicherstellt, dass das Bypassrad nicht länger mit der Einlaufsternanordnung und der Auslaufsternanordnung in Wirkverbindung steht. Aus Gründen einer besseren Wartung können allerdings auch größere Abstände sinnvoll sein.

Eine alternative Ausgestaltung sieht vor, dass die Stelleanordnung eine Schwenkvorrichtung aufweist, über die das Bypassrad zwischen der ersten und der zweiten Stellung bewegbar ist. Gemäß einer solchen Ausgestaltung wird folglich das Bypassrad verschwenkt, um die Wirkverbindung mit der Einlaufsternanordnung und der Auslaufsternanordnung zu lösen. Hierbei bieten sich grundsätzlich zwei mögliche Varianten an.

Gemäß einer ersten Variante ist das Bypassrad über die Schwenkvorrichtung um eine horizontale Schwenkachse verschwenkbar, wobei die Schwenkachse über einen Hebelarm zu dem Bypassrad beabstandet ist. Dieser Hebelarm stellt sicher, dass das Bypassrad in einem ausreichenden Abstand in der zweiten Stellung zu der Einlaufsternanordnung und der Auslaufsternanordnung beabstandet werden kann, damit Wartungsarbeiten in einfacher Art und Weise durchgeführt werden können bzw. ein einfacher Zugang zu der Ein- und Auslaufsternanordnung ermöglicht werden kann. Gemäß einer solchen Ausgestaltung schließt der Hebelarm möglichst in der Drehachse an das Bypassrad an. Bevorzugt sind der Hebel und die Drehachse fluchtend zueinander ausgebildet. Ausgehend von einer solchen Ausgestaltung kann der Schwenkwinkel zwischen der ersten und der zweiten Stellung zwischen 10° und 180° betragen.

Eine zweite Alternative sieht vor, dass das Bypassrad über die Schwenkvorrichtung um eine vertikale Schwenkachse verschwenkbar ist, wobei die Schwenkachse über den Hebelarm zur Drehachse des Bypassrades beabstandet ist. Gemäß einer solchen Ausgestaltung wird also das Bypassrad seitlich verschwenkt, wobei über den Hebelarm insbesondere sichergestellt wird, dass eine Kollision mit der Einlaufsternanordnung und der Auslaufsternanordnung verhindert wird. Der Schwenkwinkel beträgt bei einer solchen Ausgestaltung bevorzugt zwischen 10° und 90°, insbesondere zwischen 15° und 80°.

Unabhängig von der Ausgestaltung der Schwenkvorrichtung weist der Hebelarm bevorzugt einer Länge zwischen 550 mm und 650 mm, insbesondere zwischen 580 und 630 mm, auf.

Ausgehend von den zuvor genannten Lösungen kann es auch sinnvoll sein, nicht nur zwei Stellungen sondern zusätzlich eine dritte Stellung des Bypassrades vorzusehen, so dass das Bypassrad zumindest in drei Stellungen festellbar ist. Bei dieser dritten Stellung kann es sich dann um eine Wartungsstellung handeln. Entsprechend ist die zweite Stellung lediglich dazu vorgesehen, das Bypassrad dem Eingriff mit der Einlaufsternanordnung und der Auslaufsternanordnung zu entziehen. In diesem Fall ist ein vergleichsweiser geringer Abstand zwischen der ersten und der zweiten Stellung erforderlich. Dies kann beispielsweise im Fall einer Schwenkvorrichtung einem Schwenkwinkel zwischen 15° und 30° entsprechen. Die Überführung in die Wartungsstellung kann dann einem Schwenkwinkel zwischen 45° und 90° entsprechen.

Gemäß einer Weiterbildung der Erfindung ist der Stellanordnung eine Antriebseinrichtung zum Bewegen des Bypassrades zwischen der ersten und der zumindest zweiten Stellung zugeordnet. Entsprechend wird über diese Antriebseinrichtung eine Überführung des Bypassrades zwischen den Stellungen bewirkt. Bei dieser Antriebseinrichtung kann es sich um einen Elektromotor, insbesondere um einen Servo-Motor handeln. Alternativ ist auch ein Pneumatikantrieb oder ein Hydraulikantrieb denkbar. Selbstverständlich liegt es auch im Rahmen der Erfindung, anstelle einer Antriebseinrichtung eine manuelle Stelleinrichtung vorzusehen. Dies ist insbesondere im Fall einer vertikalen Schwenkachse denkbar, da in diesem Fall keine großen Kräfte aufgebracht werden müssen, um das Bypassrad zu verstellen.

Die erfindungsgemäße Beschichtungsanlage kann darüber hinaus derart ausgebildet sein, dass die Stellanordnung eine Justiereinheit aufweist, über welche das Bypassrad in einer Stellung, insbesondere in der zweiten Stellung bezüglich der Einlauf- und Auslaufsternanordnung ausgerichtet werden kann. Das Erfordernis einer Justierung wurde bereits zuvor eingehend erläutert und betrifft die Beschichtungsanlage unabhängig von der Art der Ausbildung der Stellanordnung. Die Justiereinheit kann hierbei eine vertikale und/oder eine horizontale Verstellung des Bypassrades vorsehen. Auch eine Verdrehung des Bypassrades in zumindest eine Raumrichtung ist möglich. Die Justiereinheit kann darüber hinaus eine Fixiereinrichtung umfassen, welche die Position des Bypassrades nach der Justierung fixiert. Hierdurch ist die Ausrichtung des Bypassrades insbesondere gegenüber der Einlauf- und Auslaufsternanordnung festgelegt, so dass nach einem Überführen des Bypassrades zwischen der ersten und der zweiten Stellung keine Erneute Justierung notwendig ist.

Gegenstand der Erfindung ist ferner ein Verfahren zum Betreiben einer erfindungsgemäßen Beschichtungsanlage, wobei zunächst in einem ersten Betriebszustand eine erste Gruppe von Behältern dem Beschichtungsrad zugeführt und während einer Bewegung entlang eines ersten Transportfades beschichtet werden. Insbesondere handelt es sich hierbei um eine innenliegende Beschichtung der Behälter mit dem eingangs beschriebenen Verfahren. Sodann wird anschließend in einem zweiten Betriebszustand eine zweite Gruppe von Behältern über das Bypassad entlang eines zweiten Transportpfades unter Umgehung des Beschichtungsrades bewegt, wobei der Betriebszustand durch Überführung des Bypassrades zwischen der ersten und der zweiten Stellung eingestellt wird. Insbesondere wird das Bypassrad zum Überführen zwischen der ersten und zweiten Stellung entlang einer vertikalen Achse bewegt oder entlang einer horizontalen oder vertikalen Schwenkachse verschwenkt.

Gemäß einer Weiterbildung sind die Behälter der zweiten Gruppe gegenüber den Behältern der ersten Gruppe unterschiedlich ausgebildet. Insbesondere können die Behälter größer oder kleiner ausgebildet sein als die Behälter der ersten Gruppe. Beispielsweise kann es sich bei der ersten Gruppe um Behälter mit einer Größe zwischen 150 und 1500 ml handeln, während die zweite Gruppe von Behältern eine Größe zwischen 150 und 2500 ml aufweist. Entsprechend liegt es selbstverständlich im Rahmen der Erfindung, dass die Behälter der beiden Gruppen gleich groß ausgebildet sein können. Insbesondere ist aber vorgesehen, dass ab einer Größe von 1500 ml eine Beschichtung in dem Beschichtungsrad nicht mehr ohne weiteres möglich bzw. sinnvoll ist, sodass die zweite Gruppe von Behältern bevorzugt eine Größe zwischen 1500 und 2500 ml aufweist. Bei den Behältern handelt es sich insbesondere um Getränkeflaschen aus Kunststoff, insbesondere aus Polyethylenterephthalat.

Im Folgenden wird die Erfindung anhand von Ausführungsbeispielen näher erläutert. Es zeigen:
- Fig.1: eine Draufsicht auf eine schematische Darstellung einer erfindungsgemäßen Beschichtungsanlage
- Fig. 2A, 2B: eine Beschichtungsanlage mit einer Linearführung und einem elektrischen Antrieb
- Fig. 3A, 3B: eine alternative Ausgestaltung der Beschichtungsanlage gemäß Figur 2A, 2B mit einem Pneumatikantrieb
- Fig. 4A, 4B, 4C: eine Beschichtungsanlage mit einem um eine horizontale Schwenkachse verschwenkbaren Bypassrad
- Fig. 5A, 5B: eine Beschichtungsanlage mit einem um eine vertikale Achse verschwenkbaren Bypassrad

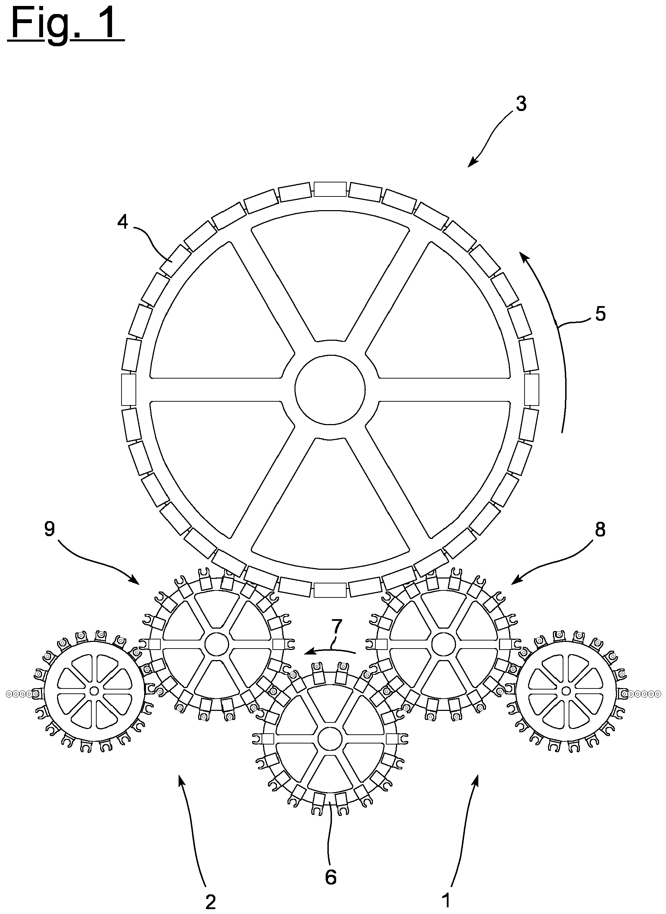

Die Fig. 1 zeigt eine erfindungsgemäße Beschichtungsanlage, welche als Behälterbeschichtungsanlage ausbildet ist, wobei es sich bei den Behältern in bevorzugter Weise um Getränkeflaschen aus Kunststoff, insbesondere aus Polyethylenterephthalat, handelt.

Die Beschichtungsanlage weist eine Einlaufsternanordnung 1 und eine Auslaufsternanordnung 2 auf, wobei zwischen der Einlaufsternanordnung 1 und Auslaufsternanordnung 2 ein Beschichtungsrad 3 mit einer Vielzahl von in Umfangsrichtung angeordneten Beschichtungseinheiten 4 angeordnet ist, welche wobei die Beschichtungseinheiten 4 jeweils nicht näher dargestellten Behälteraufnahmen zugeordnet sind. Über die Beschichtungseinheiten 4 werden die Behälter innenliegend beschichtet, wobei die Beschichtungseinheiten 4 hierzu eine Barriereschicht aus einem Plasma abscheiden. Die Beschichtung erfolgt während der Rotation der Behälter entlang des Beschichtungsrades 3. Das Beschichtungsrad 3 bildet hierzu einen ersten Transportpfad 5 aus.

Je nach verwendeten Behältern kann es auch sinnvoll sein, von einer Beschichtung abzusehen, wobei dann die Behälter an dem Beschichtungsrad 3 vorbeigeführt werden müssen. Hierzu ist ein Bypassrad 6 zwischen der Einlaufsternanordnung 1 und der Auslaufsternanordnung 2 vorgesehen. Das Bypassrad 6 bildet einen zweiten Transportpfad 7, welcher an dem Beschichtungsrad 3 vorbeiführt.

Gemäß der Figur 1 weist die Einlaufsternanordnung 1 einen unmittelbar an das Beschichtungsrad 3 angrenzenden Einlaufstern 8 und die Auslaufsternanordnung 2 einen unmittelbar an das Beschichtungsrad 3 angrenzenden Auslaufstern 9 auf, wobei das Bypassrad 6 unmittelbar mit dem Einlaufstern 8 und mit dem Auslaufstern 9 in Wirkverbindung gebracht werden kann.

Mithilfe des Bypassrades 6 wird nunmehr also ein zweiter Betriebszustand ermöglicht, in welchem von einer Beschichtung der Behälter abgesehen wird, indem die Behälter an dem Beschichtungsrad 3 vorbeigeführt werden. Um eine Einstellung zwischen dem ersten und dem zweiten Betriebszustand zu bewirken, ist es erforderlich, die Bewegung der Behälter entlang des ersten Transportpfades 5 und des zweiten Transportpfades 7 einzustellen. Hierzu bieten sich verschiedene Möglichkeiten an.

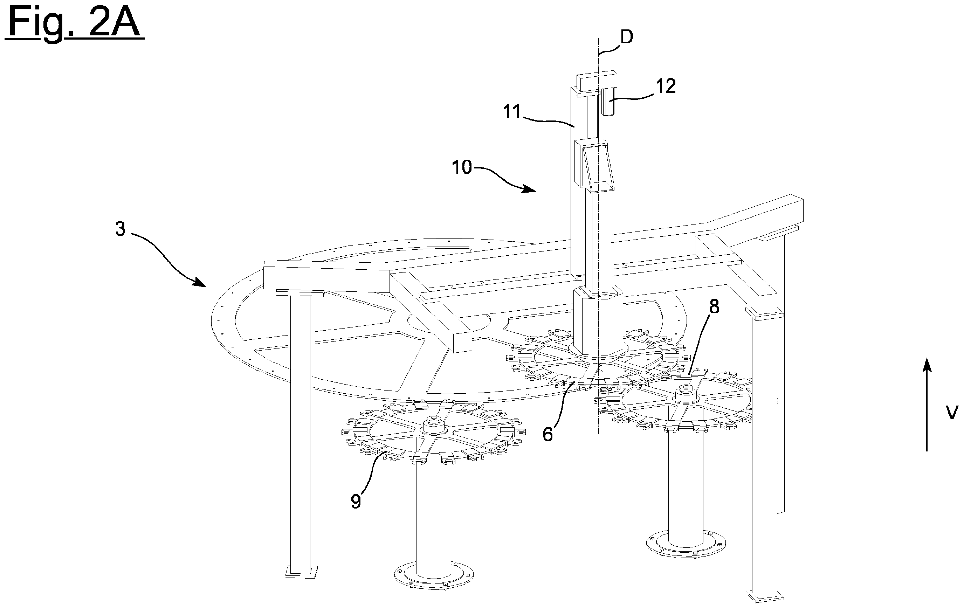

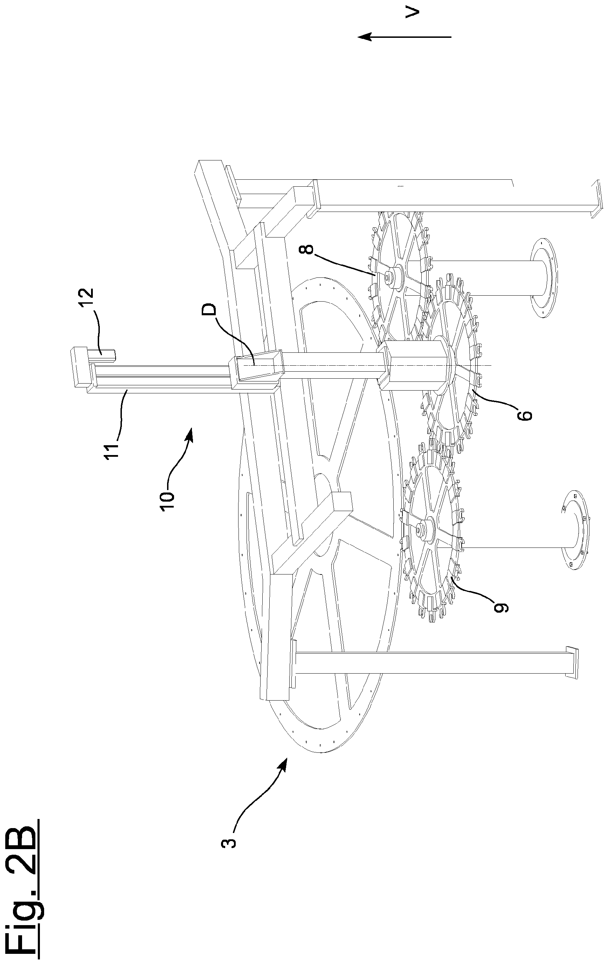

Die Fig. 2A, 2B zeigen hierbei eine erfindungsgemäße Beschichtungsanlage mit einem Bypassrad 6, welches zwischen einer in der Figur 2A dargestellten ersten Stellung und einer in der Figur 2B dargestellten zweiten Stellung überführbar ist, wobei infolge der ersten Stellung die Beschichtungsanlage im ersten Betriebszustand und mit der zweiten Stellung im zweiten Betriebszustand betrieben werden kann.

Während gemäß der Fig. 2B das Bypassrad 6 mit dem Einlaufstern 8 und dem Auslaufstern 9 in Wirkverbindung steht und entsprechend die Behälter entlang des zweiten Transportpfades 7 geführt werden, ist bezüglich der Fig. 2A vorgesehen, dass das Bypassrad 6 entlang der Drehachse D in einer Vertikalrichtung V nach oben bewegt wird, sodass folglich das Bypassrad 6 nicht länger mit dem Einlaufstern 8 und dem Auslaufstern 9 in Wirkverbindung steht. Dies wird ermöglicht über eine Stellanordnung 10, welche im Fall der in den Fig. 2A und 2B dargestellten Ausgestaltungsform als Linearführung 11 mit einer Antriebseinrichtung 12 ausgebildet ist. Bei der Antriebseinrichtung 12 handelt es sich im vorliegenden Fall um einen Servo-Motor, welcher über einen Spindeltrieb das Bypassrad 6 entlang der Linearführung 11 bewegt.

In diesem Zusammenhang ist ferner hervorzuheben, dass sowohl der Einlaufstern 8 als auch der Auslaufstern 9 und das Bypassrad 6 ausschließlich über passive Greifelemente verfügen, sodass allein durch die Stellung des Bypassrades 6 die Bewegung der Behälter entlang des ersten Transportpfades 5 bzw. des zweiten Transportpfades 7 bewirkt wird.

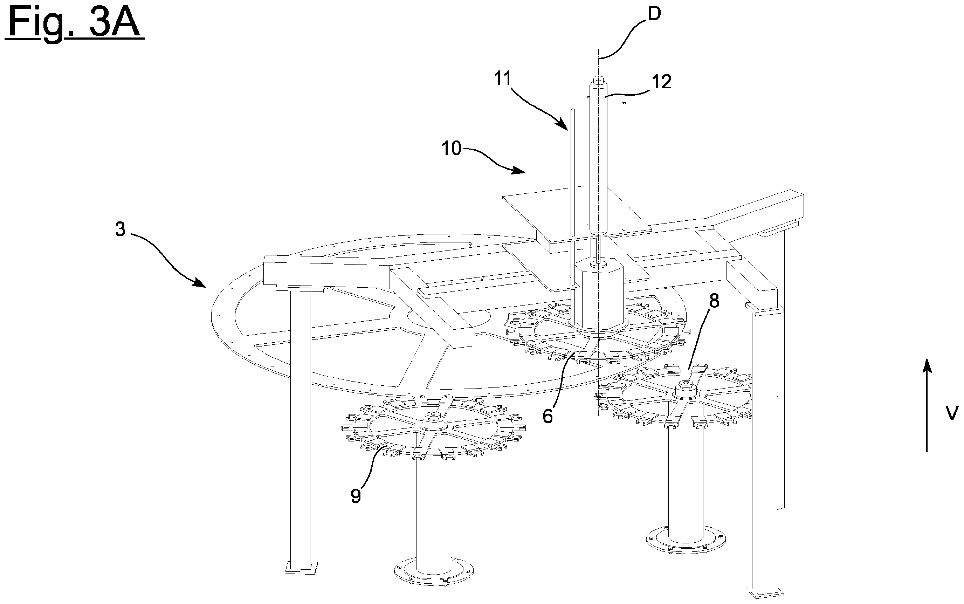

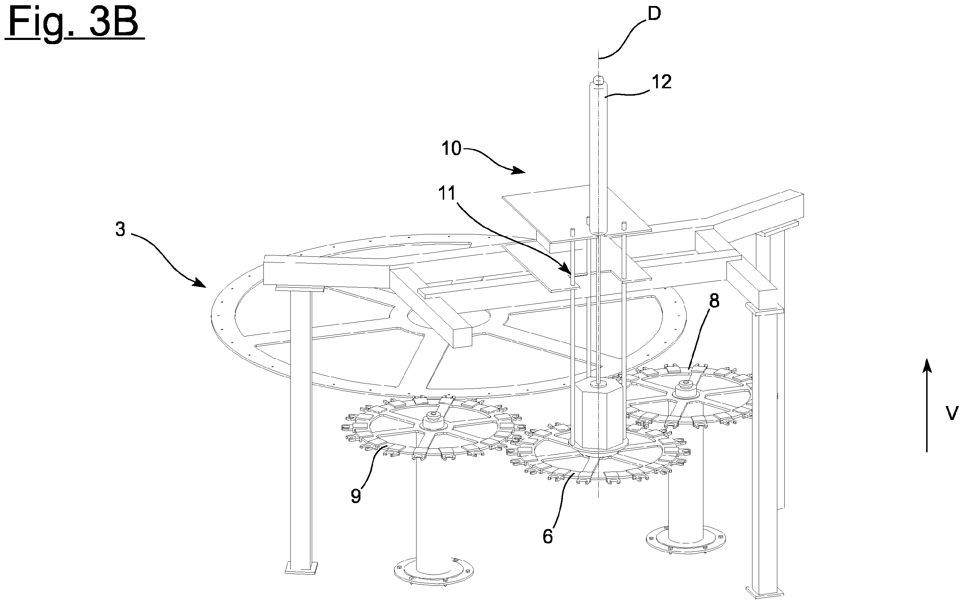

Die Fig. 3A, 3B zeigen eine alternative Ausgestaltung, wobei nunmehr das Bypassrad 6 über einen Pneumatikantrieb bewegt wird.

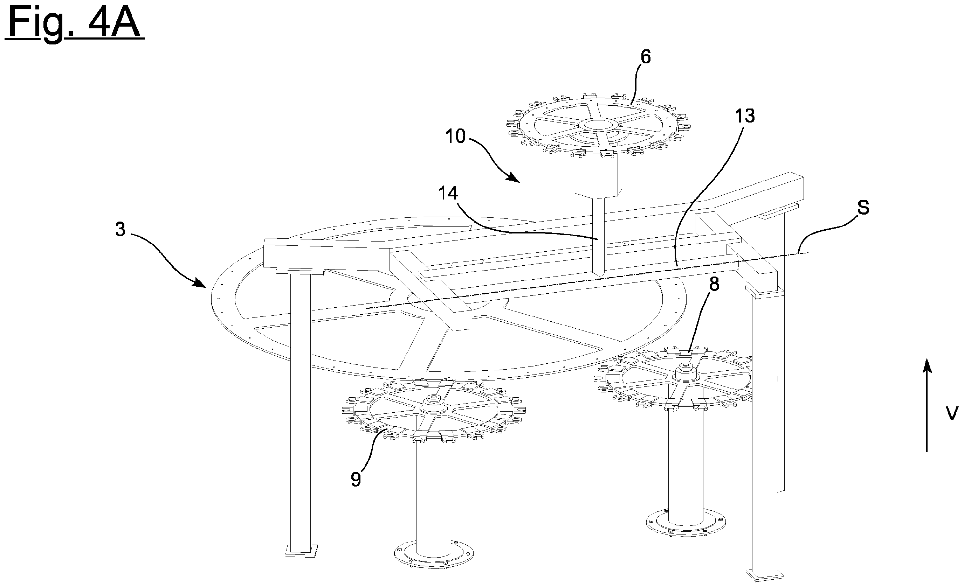

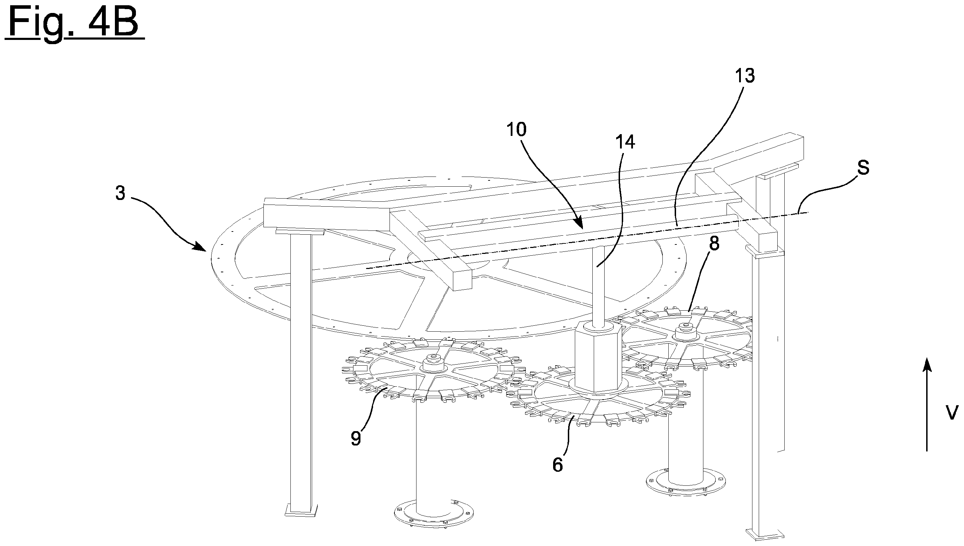

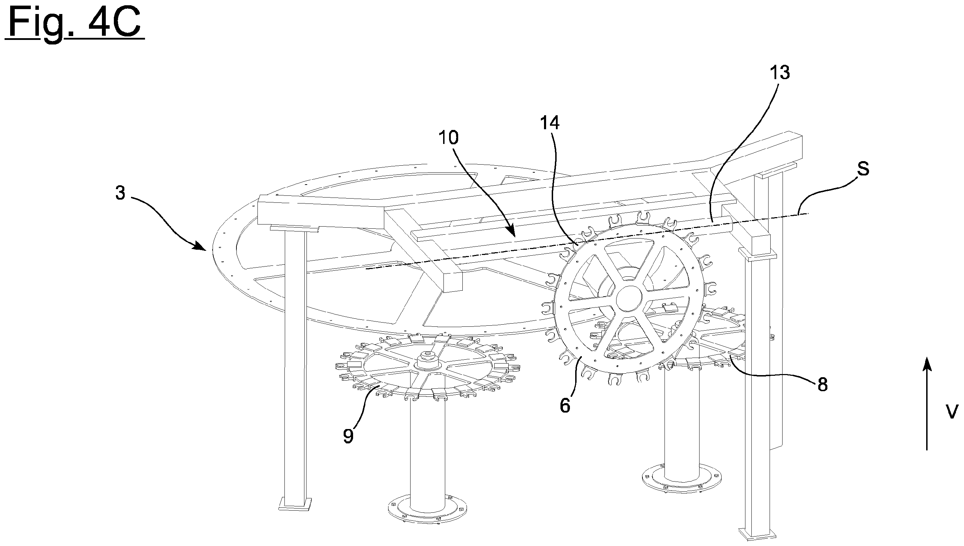

Anstelle einer Linearführung 11 sieht die Ausgestaltung gemäß den Fig. 4A, 4B, 4Cvor, dass die Stellanordnung 10 über eine Schwenkvorrichtung 13 verfügt, über die das Bypassrad 6 zwischen einer in der Fig. 4A dargestellten ersten Stellung und einer in der Fig. 4C dargestellten zweiten Stellung verschwenkt werden kann. Die Schwenkvorrichtung 13 weist eine Schwenkachse S auf, welche im vorliegenden Falle im Wesentlichen senkrecht zur Drehachse D des Bypassrades 6 ausgebildet ist und welche über einen Hebelarm 14 in der Drehachse D an das Bypassrad 6 anschließt. Die Fig. 4B zeigt darüber hinaus eine dritte Stellung, welche als Wartungsstellung vorgesehen ist.

Durch Verschwenken kann entsprechend das Bypassrad 6 gemäß der Fig. 4B mit dem Einlaufstern 8 und dem Auslaufstern 9 in Wirkverbindung gebracht werden.

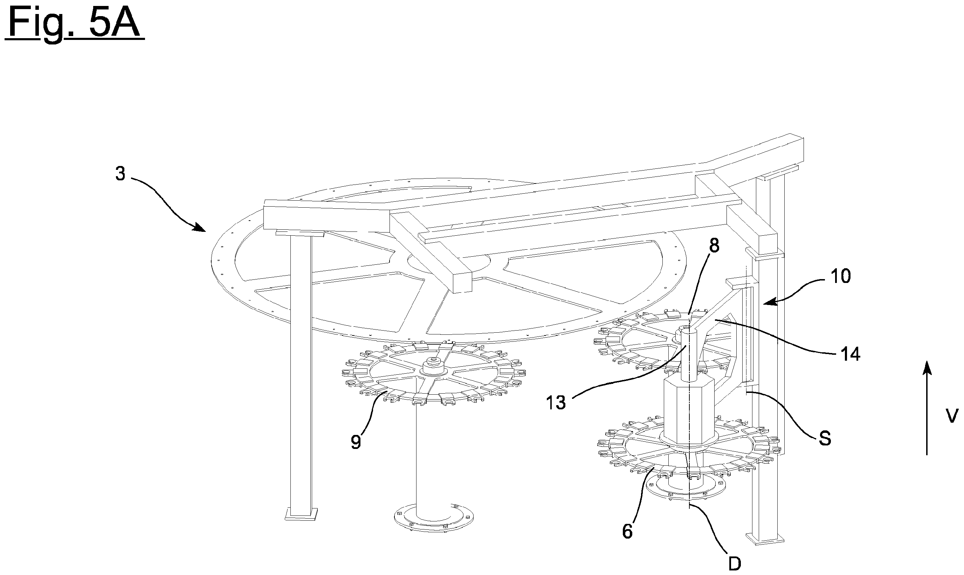

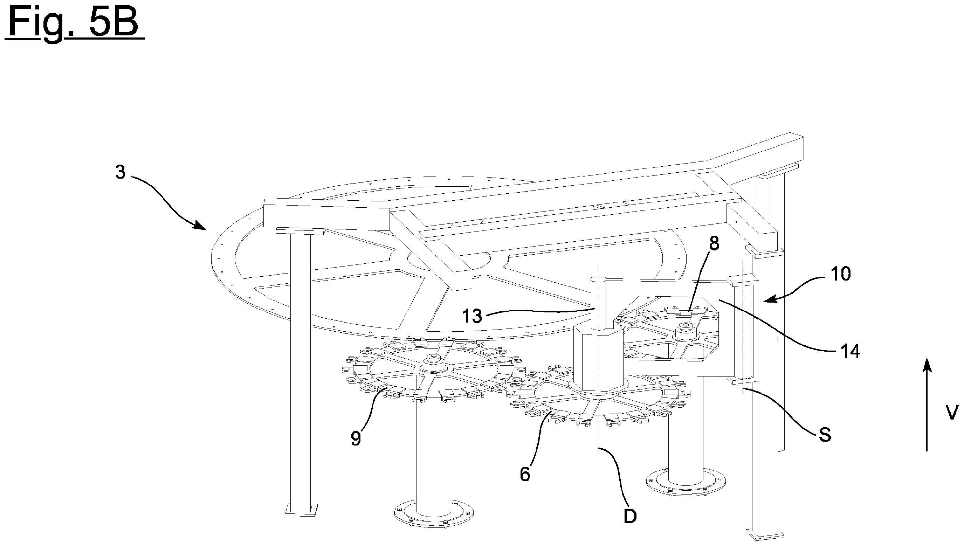

Auch gemäß der Ausgestaltung in den Fig. 5A, 5B erfolgt ein Verschwenken um eine vertikale Schwenkachse S, welche parallel zur Drehachse D angeordnet ist, wobei die Schwenkachse S über den Hebelarm 14 zur Drehachse D beabstandet ist.

### Bezugszeichenliste

- 1: Einlaufsternanordnung
- 2: Auslaufsternanordnung
- 3: Beschichtungsrad
- 4: Beschichtungseinheit
- 5: erster Transportpfad
- 6: Bypassrad
- 7: zweiter Transportpfad
- 8: Einlaufstern
- 9: Auslaufstern
- 10: Stellanordnung
- 11: Linearführung
- 12: Antriebseinrichtung
- 13: Schwenkvorrichtung
- 14: Hebelarm

- D: Drehachse
- V: Vertikalrichtung
- S: Schwenkachse

## Patentansprüche

1. Beschichtungsanlage, insbesondere Behälterbeschichtungsanlage, mit einer Einlauf- und einer Auslaufsternanordnung (1, 2) und einem dazwischen angeordneten und rotierbar antreibbaren Beschichtungsrad (3), welches eine Vielzahl von in Umfangsrichtung angeordneten Behälteraufnahmen aufweist, denen jeweils eine Beschichtungseinheit (4) zugeordnet ist, wobei die Beschichtungseinheit (4) dazu eingerichtet ist, in einem ersten Betriebszustand die Behälter während der Übergabe von der Einlauf- in die Auslaufsternanordnung (1, 2) zu beschichten und wobei zumindest ein Bypassrad (6) dazu eingerichtet ist, in einem zweiten Betriebszustand die Behälter unmittelbar von der Einlauf- in die Auslaufsternanordnung (1, 2) zu übergeben,
**dadurch gekennzeichnet, dass**
das Bypassrad (6) über eine Stellanordnung (10) zwischen einer ersten und zumindest einer zweiten Stellung überführbar ist.

2. Beschichtungsanlage nach Anspruch 1, **dadurch gekennzeichnet, dass** die Einlaufsternanordnung (1) einen Einlaufstern und die Auslaufsternanordnung (1, 2) einen Auslaufstern (9) aufweisen, welche unmittelbar an das Beschichtungsrad (3) und an das Bypassrad (6) angrenzen.

3. Beschichtungsanlage nach einem der vorangegangenen Ansprüche, **dadurch gekennzeichnet, dass** die Stellanordnung (10) eine Linearführung (11) aufweist, über die das Bypassrad (6) zwischen der der ersten und der zweiten Stellung bewegbar ist.

4. Beschichtungsanlage nach Anspruch 3, **dadurch gekennzeichnet, dass** die Linearführung (11) im Wesentlichen parallel zur Drehachse (D) des Bypassrades (6) angeordnet ist.

5. Beschichtungsanlage nach Anspruch 3 oder 4, wobei die Position der Drehachse (D) des Bypassrades (6) in der zweiten Stellung zwischen 70 und 1700 mm von der Position in der ersten Stellung beabstandet ist.

6. Beschichtungsanlage nach Anspruch 1 oder 2, **dadurch gekennzeichnet, dass** die Stellanordnung (10) eine Schwenkvorrichtung (13) aufweist, über die das Bypassrad (6) zwischen der ersten und der zweiten Stellung bewegbar ist.

7. Beschichtungsanlage nach Anspruch 6, **dadurch gekennzeichnet, dass** das Bypassrad (6) über die Schwenkvorrichtung (13) um eine horizontale Schwenkachse (S) verschwenkbar ist, wobei die Schwenkachse (S) über einen Hebelarm (14) zu dem Bypassrad (6) beabstandet ist.

8. Beschichtungsanlage nach Anspruch 6, **dadurch gekennzeichnet, dass** das Bypassrad (6) über die Schwenkvorrichtung (13) um eine vertikale Schwenkachse (S) verschwenkbar ist, wobei die Schwenkachse (S) über den Hebelarm (14) zur Drehachse (D) des Bypassrades (6) beabstandet ist.

9. Beschichtungsanlage nach Anspruch 7 oder 8, **dadurch gekennzeichnet, dass** der Hebel eine Länge zwischen 550 mm und 650 mm aufweist.

10. Beschichtungsanlage nach einem der vorangegangenen Ansprüche, **dadurch gekennzeichnet, dass** das Bypassrad (6) in eine Wartungsstellung überführbar ist.

11. Beschichtungsanlage nach einem der vorangegangenen Ansprüche, **dadurch gekennzeichnet, dass** der Stellanordnung (10) eine Antriebseinrichtung (12) zum Bewegen des Bypassrades (6) zwischen der ersten und der zweiten Stellung zugeordnet ist.

12. Beschichtungsanlage nach Anspruch 11, **dadurch gekennzeichnet, dass** die Antriebseinrichtung (12) ein Elektromotor, insbesondere Servo-Motor, ein Pneumatikantrieb oder ein Hydraulikantrieb ist.

13. Beschichtungsanlage nach einem der vorangegangenen Ansprüche, **dadurch gekennzeichnet, dass** die Einlaufsternanordnung (1) und/oder die Auslaufsternanordnung (2) passive Greifer aufweist.

14. Beschichtungsanlage nach einem der vorangegangenen Ansprüche, **dadurch gekennzeichnet, dass** das Bypassrad (6) aktive Greifer aufweist.

15. Beschichtungsanlage nach einem der vorangegangenen Ansprüche, **dadurch gekennzeichnet, dass** die Stellanordnung (10) eine Justiereinheit aufweist, über welche das Bypassrad (6) in einer Stellung bezüglich der Einlauf- und Auslaufsternanordnung (1, 2) ausgerichtet werden kann.

16. Beschichtungsanlage nach einem der vorangegangenen Ansprüche, **dadurch gekennzeichnet, dass** das Bypassrad in zumindest drei Stellungen feststellbar ist.

17. Verfahren zum Betreiben einer Beschichtungsanlage nach einem der vorangegangenen Ansprüche, **dadurch gekennzeichnet, dass** zunächst in einem ersten Betriebszustand eine erste Gruppe von Behältern dem Beschichtungsrad zugeführt und während einer Bewegung entlang eines ersten Transportpfades (5) beschichtet werden und wobei anschließend in einem zweiten Betriebszustand eine zweite Gruppe von Behältern über das Bypassrad (6) entlang eines zweiten Transportpfades (7) unter Umgehung des Beschichtungsrades (3) bewegt werden und wobei der Betriebszustand durch Überführen des Bypassrades (6) zwischen der ersten und der zweiten Stellung eingestellt wird.

18. Verfahren nach Anspruch 17, **dadurch gekennzeichnet, dass** die Behälter der zweiten Gruppe gegenüber den Behältern der ersten Gruppe unterschiedlich ausgebildet sind.
